# EUROPEAN PATENT SPECIFICATION

(11) **EP 3 872 871 B1**
(45) Date of publication and mention of the grant of the patent: **04.11.2026**
(21) Application number: 19877321.0
(22) Date of filing: 02.09.2019
(51) Int. Cl.: H10H 20/831, H10H 20/833, H10H 29/30, H10H 20/811, H10H 20/819, H10H 20/01, H10H 20/84, H10H 20/852

(54) **SEMICONDUCTOR LIGHT-EMITTING DIODE AND DISPLAY DEVICE INCLUDING SAME**
LICHTEMITTIERENDE HALBLEITERDIODE UND ANZEIGEVORRICHTUNG DAMIT
DIODE ÉLECTROLUMINESCENTE À SEMI-CONDUCTEUR ET DISPOSITIF D'AFFICHAGE LE COMPRENANT

(30) Priority: 23.10.2018 KR 20180126680
(43) Date of publication of application: 01.09.2021
(73) Proprietor: LG Electronics Inc., Seoul 07336 (KR)
(72) Inventor: SUNG, Junho, Seoul 06772 (KR)
(74) Representative: Vossius & Partner Patentanwälte Rechtsanwälte mbB
(86) International application number: PCT/KR2019/011241
(87) International publication number: WO 2020/085640

(56) References cited:
- WO-A2-2017/187166
- CN-A- 104 051 587
- JP-A- 2007 214 260
- KR-A- 20100 104 718
- KR-A- 20100 104 718
- KR-A- 20110 103 686
- KR-A- 20140 047 803
- KR-B1- 101 907 542
- US-A1- 2008 296 602

## Description

### [Technical Field]

The present invention relates to a semiconductor light emitting device, a method of manufacturing the same, and a display device including the semiconductor light emitting device.

### [Background Art]

Recently, in the field of display technology, a display device having excellent characteristics such as thin and flexible has been developed. On the contrary, the main commercial displays are represented by LCD (Liquid Crystal Display) and AMOLED (Active-Matrix Organic Light Emitting Diodes).

However, in the case of LCD, there is a problem in that the reaction time is not fast and it is difficult to implement the flexible, and in the case of AMOLED, there is a vulnerability in that the life is short and the mass production yield is not good.

Meanwhile, a light emitting diode (LED) is a well-known semiconductor light emitting device that converts current into light, and in 1962 a red LED using a GaAsP compound semiconductor was commercialized. Also, it has been used as a light source for display images in electronic devices including information and communication devices along with GaP:N series green LEDs. Accordingly, a method for solving the above problems by implementing a display using the semiconductor light emitting device may be proposed. These light-emitting diodes have various advantages, such as long life, low power consumption, excellent initial driving characteristics, and high vibration resistance compared to a filament-based light-emitting device.

Therefore, in recent years, research and development on display devices using micro-semiconductor light emitting devices are in progress, and these display devices are in the spotlight as next-generation displays because they have high quality and high reliability.

However, in order to increase the resolution of a display using a micro-semiconductor light-emitting device, the size of the micro-semiconductor light-emitting device must be miniaturized to within several to tens of micrometers.

The micro-semiconductor light emitting device is composed of an n-type semiconductor layer to which electrons are supplied, a p-type semiconductor layer to which holes are supplied, and an active layer that generates light by recombining electrons and holes. The thickness of the micro-semiconductor light emitting device is generally several micrometers, and the size of the planar device may be defined through dry etching in a vertical direction. Accordingly, an etching surface of each layer may exist on the side of the outer portion of the device exposed through dry etching. An unstable surface state having an energy level lower than that of the semiconductor band gap may exist on the surface of the etched surface or inside the semiconductor layer adjacent to the surface. Due to the unstable surface state, non-luminescent recombination between electrons and holes occurs in the outer portion of the device, which may reduce the efficiency of light-emitting recombination emitted from the active layer.

The range in which the non-luminescent recombination at the outer part of the device affects is about several micrometers. As the device becomes smaller, the effect of the non-luminescence recombination increases, and the internal quantum efficiency of the micro-semiconductor light emitting device rapidly decreases.

KR 2010 0104718 A and KR 2011 0103686 A describe a nitrides light emitting device selectively using the coupling effect between surface plasmons and the active layer. KR 2014 00047803 A describes a light emitting device and light emitting device package. CN 104 051 587 A discloses a manufacturing method of surface-plasmon-enhanced GaN-based nanopore LED.

### [Disclosure]

### [Technical Problem]

A problem to be solved by the present invention is to provide a semiconductor light emitting device capable of minimizing a decrease in internal quantum efficiency due to miniaturization of a semiconductor light emitting device.

Another problem to be solved by the present invention is to provide a semiconductor light emitting device capable of suppressing non-emission surface recombination occurring in a semiconductor light emitting device through surface plasmon resonance.

### [Technical Solution]

The present invention is defined by independent claim 1; the dependent claims define embodiments of the present invention.

A semiconductor light emitting device according to an embodiment of the present invention includes a growth substrate, a first conductivity type semiconductor layer formed on the growth substrate, an active layer formed in a partial region on the first conductivity type semiconductor layer, and a second conductivity type semiconductor layer formed on the active layer, a trench formed by etching a portion of a top surface of the second conductivity type semiconductor layer, a second conductivity type semiconductor high concentration doped layer formed on the second conductivity type semiconductor layer, wherein the trench is etched from a partial region of the surface of the second conductivity type semiconductor high concentration doped layer, and a plurality of metal nanoparticles inserted into the trench.

According to the invention, the trench is formed in a region spaced apart from a center of the surface of the second conductivity type semiconductor layer.

The semiconductor light emitting device further includes a first electrode connected to the first conductivity type semiconductor layer, and a second electrode spaced apart from the first electrode and connected to the second conductivity type semiconductor layer or the second conductivity type semiconductor high concentration doped layer, the second electrode connected to be in contact with the central portion of the surface of the second conductivity type semiconductor layer or the second conductivity type semiconductor high concentration doped layer (1005).

The semiconductor light emitting device of the present invention further comprises a passivation insulating layer disposed between the metal nanoparticles and the second electrode, the passivation layer covering the first and second semiconductor layers, the active layer, and the second conductivity type semiconductor high concentration doped layer exposed thereon.

According to an embodiment, the first electrode and the second electrode may be implemented as transparent electrodes.

According to an embodiment, a depth from a surface of the second conductivity type semiconductor layer to a bottom surface of the trench may be smaller than a thickness of the second conductivity type semiconductor layer.

According to an embodiment, the bottom surface of the trench may be positioned closer to an upper surface of the active layer than the surface of the second conductivity type semiconductor layer.

The metal nanoparticles may include silver, aluminum, or gold.

A method of manufacturing a semiconductor light emitting device may include a step of sequentially stacking and forming a first conductivity type semiconductor layer, an active layer, and a second conductivity type semiconductor layer on a growth substrate. In addition, the method may include etching the first region of the first conductivity-type semiconductor layer, the active layer, and the second conductivity-type semiconductor layer to expose the first conductivity-type semiconductor layer upward from the first region. In addition, the method may include forming a trench by etching a portion of the second region excluding the first region, and inserting metal nanoparticles into the trench. In addition, the method may include forming a passivation insulating layer on the first conductivity-type semiconductor layer, the active layer, the second conductivity-type semiconductor layer, the trench, and the metal nanoparticles. In addition, the method may include etching a portion of the passivation insulating layer so that a portion of a upper surface of the first conductivity type semiconductor layer and a portion of the upper surface of the second conductivity type semiconductor layer are exposed, and forming a first electrode connected to the portion of the upper surface of the first conductivity type semiconductor layer and a second electrode connected to the portion of the upper surface of the second conductivity type semiconductor layer.

The step of etching a portion of the passivation insulating layer may be a step of etching a portion of the passivation insulating layer so that a central portion of the upper surface of the second conductivity type semiconductor layer is exposed.

According to an embodiment, the passivation insulating layer may be implemented with silica or alumina.

### [Advantageous Effects]

According to an embodiment of the present invention, the semiconductor light emitting device may improve internal quantum efficiency by suppressing non-emission recombination of the semiconductor light emitting device through surface plasmon resonance between light generated in the active layer and metal nanoparticles. Accordingly, when the semiconductor light-emitting device is miniaturized, it is possible to prevent a rapid decrease in internal quantum efficiency due to non-emission recombination, and thus a miniaturized semiconductor light-emitting device may be implemented.

In addition, the semiconductor light emitting device can maximize the effect of surface plasmon resonance by minimizing the distance between the metal nanoparticles and the active layer through a trench structure formed in the semiconductor layer.

In addition, the trench structure may be formed to be spaced apart from a central portion of the surface of the semiconductor layer, and electrodes may be connected through at least a portion of the central portion. Accordingly, when the semiconductor light emitting device is driven, the flow of current may be concentrated to the center. As a result, since the amount of current flowing to the outer portion (etching surface) of the semiconductor layer is reduced, the frequency of non-luminescent surface recombination occurring on the etching surface is reduced, and thus internal quantum efficiency can be improved.

In addition, since the semiconductor light emitting device includes a high-concentration doping layer for compensating for a decrease in characteristics due to a trench structure formed in the semiconductor layer, it is possible to prevent a decrease in luminous efficiency due to the decrease in the characteristics.

### [Description of Drawings]

FIG. 1 is a conceptual diagram showing an embodiment of a display device using a semiconductor light emitting device of the present invention.
FIG. 2 is a partially enlarged view of portion A of FIG. 1, and FIGS. 3A and 3B are cross-sectional views taken along lines B-B and C-C of FIG. 2.
FIG. 4 is a conceptual diagram illustrating the flip chip type semiconductor light emitting device of FIG. 3.
FIGS. 5A to 5C are conceptual diagrams showing various forms of implementing colors in relation to a flip chip type semiconductor light emitting device.
FIG. 6 is a cross-sectional view showing a method of manufacturing a display device using the semiconductor light emitting device of the present invention.
FIG. 7 is a perspective view showing another embodiment of a display device using the semiconductor light emitting device of the present invention.
FIG. 8 is a cross-sectional view taken along the line D-D of FIG. 7.
FIG. 9 is a conceptual diagram showing the vertical semiconductor light emitting device of FIG. 8.
FIG. 10 is a diagram illustrating a structure of a semiconductor light emitting device according to an embodiment of the present invention.
FIG. 11A to 11B are cross-sectional views illustrating a method of manufacturing a semiconductor light emitting device according to the embodiment illustrated in FIG. 10.
FIG. 12 is a diagram illustrating a structure of a semiconductor light emitting device according to another embodiment of the present invention.
FIG. 13 is a diagram illustrating a structure of a semiconductor light emitting device according to another embodiment of the present invention.
FIG. 14 is a diagram illustrating a structure of a semiconductor light emitting device according to another embodiment of the present invention.

### [Mode for Invention]

Hereinafter, exemplary embodiments disclosed in the present specification will be described in detail with reference to the accompanying drawings, but identical or similar elements are denoted by the same reference numerals regardless of reference numerals, and redundant descriptions thereof will be omitted. The suffixes "module" and "unit" for constituent elements used in the following description are given or used interchangeably in consideration of only the ease of preparation of the specification, and do not themselves have distinct meanings or roles. In addition, in describing the embodiments disclosed in the present specification, when it is considered that a detailed description of related known technologies may obscure the subject matter of the embodiments disclosed in the present specification, the detailed description thereof will be omitted. In addition, it should be noted that the accompanying drawings are for easy understanding of the embodiments disclosed in the present specification and should not be construed as limiting the technical spirit disclosed in the present specification by the accompanying drawings.

Further, when an element such as a layer, region or substrate is referred to as being "on" another component, it will be able to understand such as it may be directly on another element or there may be an intermediate element between them.

The display device described herein includes a mobile phone, a smart phone, a laptop computer, a digital broadcasting terminal, a personal digital assistant (PDA), a portable multimedia player (PMP), a navigation system, and a slate PC, Tablet PC, Ultra Book, digital TV, desktop computer, etc. However, it will be readily apparent to those skilled in the art that the configuration according to the embodiment described in the present specification may be applied to a device capable of displaying even in a new product type to be developed later.

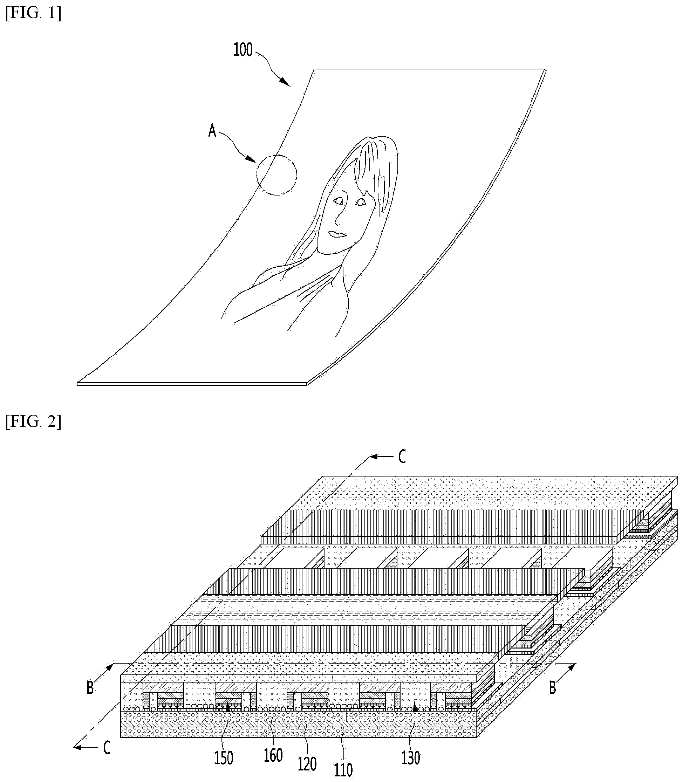

FIG. 1 is a conceptual diagram showing an embodiment of a display device using a semiconductor light emitting device of the present invention.

As illustrated, information processed by the controller of the display apparatus 100 may be displayed using a flexible display.

Flexible displays may include displays that are bendable, yielding, twistable, foldable, and rollable by an external force. For example, the flexible display may be a display manufactured on a thin and flexible substrate that can be bent, yielded, folded, or rolled like paper while maintaining the display characteristics of a conventional flat panel display.

In a state in which the flexible display is not bent (for example, a state having an infinite radius of curvature, hereinafter referred to as a first state), the display area of the flexible display becomes a flat surface. In a state that is bent by an external force in the first state (for example, a state having a finite radius of curvature, hereinafter referred to as a second state), the display area may be a curved surface. As illustrated, the information displayed in the second state may be visual information output on a curved surface. Such visual information is implemented by independently controlling light emission of sub-pixels arranged in a matrix form. The sub-pixel means a minimum unit for implementing one color.

The sub-pixel of the flexible display may be implemented by a semiconductor light emitting device. In the present invention, a light emitting diode (LED) is exemplified as a kind of semiconductor light emitting device that converts current into light. The light emitting diode is formed in a small size, and through this, it can serve as a sub-pixel even in the second state.

Hereinafter, a flexible display implemented using the light emitting diode will be described in more detail with reference to the drawings.

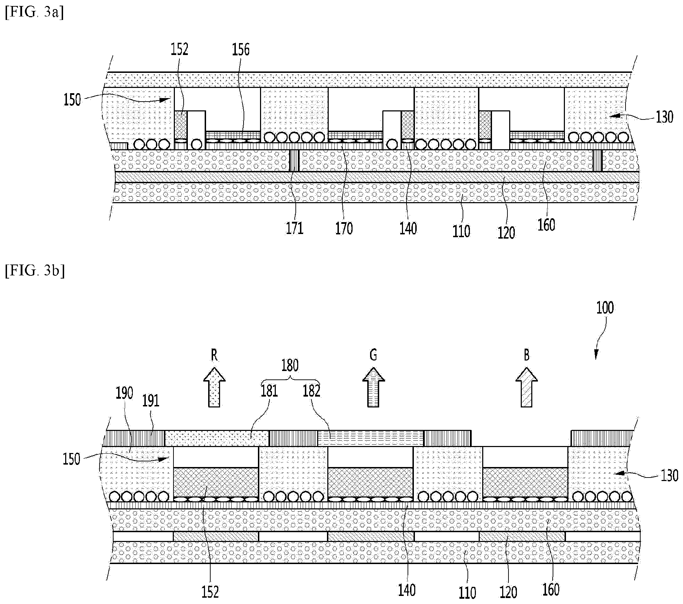

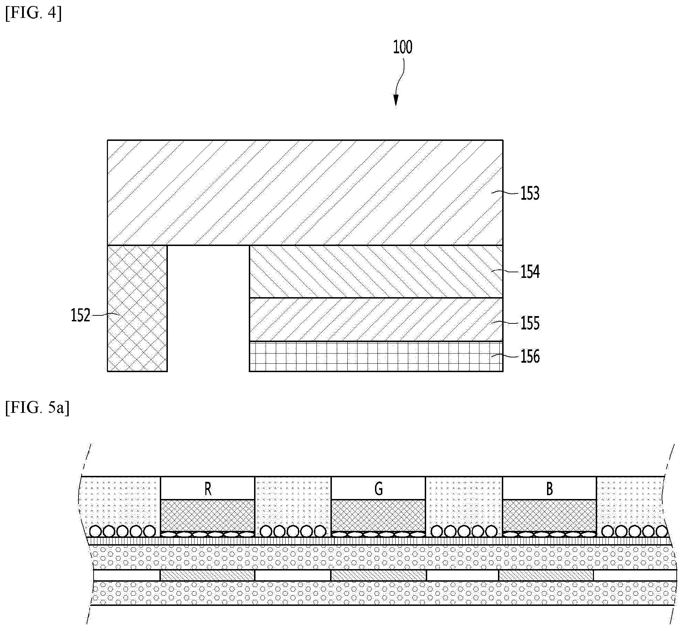

FIG. 2 is a partially enlarged view of part A of FIG. 1, FIGS. 3A and 3B are cross-sectional views taken along lines BB and CC of FIG. 2, and FIG. 4 is a view showing the flip chip type semiconductor light emitting device of FIG. 3A. And FIGS. 5A to 5C are conceptual diagrams illustrating various forms of implementing colors in relation to a flip chip type semiconductor light emitting device.

Referring to FIGS. 2, 3A, and 3B, a display device 100 using a passive matrix (PM) type semiconductor light emitting device is illustrated as a display device 100 using a semiconductor light emitting device. However, the embodiment described below is applicable to an active matrix (AM) type semiconductor light emitting device.

The display device 100 may include a substrate 110, a first electrode 120, a conductive adhesive layer 130, a second electrode 140, and a plurality of semiconductor light emitting devices 150.

The substrate 110 may be a flexible substrate. For example, in order to implement a flexible display device, the substrate 110 may include glass or polyimide (PI). In addition, any material such as polyethylene naphthalate (PEN) and polyethylene terephthalate (PET) may be used as long as it is an insulating and flexible material. In addition, the substrate 110 may be a transparent material or an opaque material.

The substrate 110 may be a wiring board on which the first electrode 120 is disposed, and thus the first electrode 120 may be positioned on the substrate 110.

As shown in the drawing, the insulating layer 160 may be disposed on the substrate 110 on which the first electrode 120 is located, and the auxiliary electrode 170 may be disposed on the insulating layer 160. In this case, a state in which the insulating layer 160 is stacked on the substrate 110 may be a single wiring board. More specifically, the insulating layer 160 is made of an insulating and flexible material such as polyimide (PI), PET, and PEN, and may be formed integrally with the substrate 110 to form a single substrate.

The auxiliary electrode 170 is an electrode that electrically connects the first electrode 120 and the semiconductor light emitting device 150, is located on the insulating layer 160, and is disposed corresponding to the position of the first electrode 120. For example, the auxiliary electrode 170 has a dot shape and may be electrically connected to the first electrode 120 by an electrode hole 171 penetrating through the insulating layer 160. The electrode hole 171 may be formed by filling a via hole with a conductive material.

Referring to the drawings, a conductive adhesive layer 130 is formed on one surface of the insulating layer 160, but the present invention is not limited thereto. For example, a layer performing a specific function may be formed between the insulating layer 160 and the conductive adhesive layer 130. In addition, a structure in which the conductive adhesive layer 130 is disposed on the substrate 110 without the insulating layer 160 is also possible. In a structure in which the conductive adhesive layer 130 is disposed on the substrate 110, the conductive adhesive layer 130 may serve as an insulating layer.

The conductive adhesive layer 130 may be a layer having adhesiveness and conductivity, and for this purpose, a conductive material and a material having adhesiveness may be mixed in the conductive adhesive layer 130. **In** addition, the conductive adhesive layer 130 has ductility, thereby enabling a flexible function in the display device.

As such an example, the conductive adhesive layer 130 may be an anisotropic conductive film (ACF), an anisotropic conductive paste, a solution containing conductive particles, or the like. The conductive adhesive layer 130 allows electrical interconnection in the Z direction penetrating through the thickness, but may be configured as a layer having electrical insulation in the horizontal X-Y direction. Therefore, the conductive adhesive layer 130 may be referred to as a Z-axis conductive layer (however, hereinafter referred to as 'conductive adhesive layer').

The anisotropic conductive film is a film in which an anisotropic conductive medium is mixed with an insulating base member, and when heat and pressure are applied, only a specific portion becomes conductive by the anisotropic conductive medium. Hereinafter, it will be described that heat and pressure are applied to the anisotropic conductive film, but other methods are possible in order for the anisotropic conductive film to partially have conductivity. Such a method may be, for example, the application of only one of the above heat and pressure, or UV curing or the like.

In addition, the anisotropic conductive medium may be, for example, conductive balls or conductive particles. As shown in the drawing, in this example, the anisotropic conductive film is a film in which conductive balls are mixed with an insulating base member, and when heat and pressure are applied, only a specific portion becomes conductive by the conductive balls. In the anisotropic conductive film, a core of a conductive material may contain a plurality of particles covered by an insulating film made of a polymer material, and in this case, a portion to which heat and pressure is applied is destroyed by the insulating film and becomes conductive by the core. At this time, the shape of the core may be deformed to form a layer in contact with each other in the thickness direction of the film. As a more specific example, heat and pressure are applied to the anisotropic conductive film as a whole, and an electrical connection in the Z-axis direction is partially formed due to a height difference of a counterpart adhered by the anisotropic conductive film.

As another example, the anisotropic conductive film may contain a plurality of particles coated with a conductive material on an insulating core. In this case, the conductive material is deformed (or pressed) on the part to which heat and pressure are applied, so that it has conductivity in the thickness direction of the film. As another example, a form in which the conductive material penetrates the insulating base member in the Z-axis direction and has conductivity in the thickness direction of the film is also possible. In this case, the conductive material may have a pointed end.

According to the illustration, the anisotropic conductive film may be a fixed array ACF having a conductive ball inserted into one surface of an insulating base member. More specifically, the insulating base member is formed of an adhesive material, and the conductive ball is intensively disposed on the bottom portion of the insulating base member,

However, the present invention is not necessarily limited thereto, and the anisotropic conductive film has a form in which conductive balls are randomly mixed in an insulating base member, or includes a plurality of layers, and a form in which conductive balls are arranged in any one layer (double-ACF) or like are all possible.

The anisotropic conductive paste can be a combination of a paste and conductive balls, and may be a paste in which conductive balls are mixed with an insulating and adhesive base material. In addition, the solution containing conductive particles may be a solution containing conductive particles or nano particles.

Referring back to the drawings, the second electrode 140 can be positioned on the insulating layer 160 to be spaced apart from the auxiliary electrode 170. That is, the conductive adhesive layer 130 is disposed on the insulating layer 160 on which the auxiliary electrode 170 and the second electrode 140 are located.

A conductive adhesive layer 130 is formed on the insulating layer 160 with the auxiliary electrode 170 and the second electrode 140 positioned on the insulating layer 160. Thereafter, when the semiconductor light emitting device 150 is connected in a flip chip form by applying heat and pressure, the semiconductor light emitting device 150 can be electrically connected to the first electrode 120 and the second electrode 140.

Referring to FIG. 4, the semiconductor light emitting device may be a flip chip type light emitting device.

For example, the semiconductor light emitting device may include a p-type electrode 156, a p-type semiconductor layer 155 on which the p-type electrode 156 is formed, and an active layer 154 formed on the p-type semiconductor layer 155, a n-type semiconductor layer 153 formed on the active layer 154 and an n-type electrode 152 disposed horizontally apart from the p-type electrode 156 on the n-type semiconductor layer 153. **In** this case, the p-type electrode 156 may be electrically connected to the auxiliary electrode 170 and the conductive adhesive layer 130, and the n-type electrode 152 may be electrically connected to the second electrode 140.

Referring again to FIGS. 2, 3A, and 3B, the auxiliary electrode 170 is formed to be elongated in one direction, so that one auxiliary electrode may be electrically connected to the plurality of semiconductor light emitting devices 150. For example, p-type electrodes of the left and right semiconductor light emitting devices around the auxiliary electrode may be electrically connected to one auxiliary electrode.

More specifically, the semiconductor light emitting device 150 may be pressed into the conductive adhesive layer 130 by heat and pressure. Accordingly, only the portion between the p-type electrode 156 and the auxiliary electrode 170 of the semiconductor light emitting device 150 and the portion between the n-type electrode 152 and the second electrode 140 of the semiconductor light emitting device 150 have conductivity, and there is no press-fitting of the semiconductor light emitting device in the rest of the part, so it does not have conductivity. In this way, the conductive adhesive layer 130 not only mutually couples the semiconductor light emitting device 150 and the auxiliary electrode 170 and between the semiconductor light emitting device 150 and the second electrode 140, but also forms an electrical connection.

In addition, the plurality of semiconductor light emitting devices 150 constitute a light emitting device array, and a phosphor layer 180 is formed in the light emitting device array.

The light emitting device array may include a plurality of semiconductor light emitting devices having different luminance values. Each semiconductor light emitting device 150 constitutes a unit pixel and is electrically connected to the first electrode 120. For example, there may be a plurality of first electrodes 120, semiconductor light emitting devices are arranged in, for example, several rows, and semiconductor light emitting devices in each row may be electrically connected to any one of the plurality of first electrodes.

Further, since the semiconductor light emitting devices are connected in a flip-chip form, semiconductor light emitting devices grown on a transparent dielectric substrate can be used. In addition, the semiconductor light emitting devices may be, for example, nitride semiconductor light emitting devices. Since the semiconductor light emitting device 150 has excellent luminance, individual unit pixels can be configured even with a small size.

According to the illustration, a partition wall 190 may be formed between the semiconductor light emitting devices 150. In this case, the partition wall 190 may serve to separate individual unit pixels from each other, and may be integrally formed with the conductive adhesive layer 130. For example, by inserting the semiconductor light emitting device 150 into the anisotropic conductive film, the base member of the anisotropic conductive film may form the partition wall.

In addition, when the base member of the anisotropic conductive film is black, the partition wall 190 may have reflective properties and increase contrast even without a separate black insulator.

As another example, a reflective partition wall may be separately provided as the partition wall 190. In this case, the partition wall 190 may include a black or white insulator depending on the purpose of the display device. When a partition wall of a white insulator is used, there may be an effect of increasing reflectivity, and when a partition wall of a black insulator is used, it is possible to increase the contrast while having reflective characteristics.

The phosphor layer 180 may be positioned on the outer surface of the semiconductor light emitting device 150. For example, the semiconductor light emitting device 150 can be a blue semiconductor light emitting device that emits blue (B) light, and the phosphor layer 180 performs a function of converting the blue (B) light into a color of a unit pixel. The phosphor layer 180 may be a red phosphor 181 or a green phosphor 182 constituting individual pixels.

That is, at a position constituting a red unit pixel, a red phosphor 181 capable of converting blue light into red (R) light may be stacked on a blue semiconductor light emitting device, and at a position constituting a green unit pixel, a green phosphor 182 capable of converting blue light into green (G) light may be stacked on the blue semiconductor light emitting device. In addition, only a blue semiconductor light emitting device may be used alone in a portion constituting a blue unit pixel. In this case, unit pixels of red (R), green (G), and blue (B) may form one pixel. More specifically, a phosphor of one color may be stacked along each line of the first electrode 120. Accordingly, one line of the first electrode 120 may be an electrode that controls one color. That is, along the second electrode 140, red (R), green (G), and blue (B) may be sequentially disposed, and a unit pixel may be implemented through this.

However, the present invention is not necessarily limited thereto, and a semiconductor light emitting device 150 and a quantum dot (QD) are combined instead of a phosphor to implement a unit pixel of red (R), green (G), and blue (B).

In addition, a black matrix 191 may be disposed between the respective phosphor layers to improve contrast. That is, such a black matrix 191 may improve contrast of light and dark.

However, the present invention is not necessarily limited thereto, and other structures for implementing blue, red, and green colors may be applied.

Referring to FIG. 5A, each semiconductor light emitting device 150 is mainly made of gallium nitride (GaN), and indium (In) and/or aluminum (Al) are added together to emit various lights including blue such that it can be implemented as a high-power light-emitting device.

In this case, the semiconductor light emitting device 150 may be a red, green, and blue semiconductor light emitting device to form a sub-pixel, respectively. For example, red, green, and blue semiconductor light emitting devices (R, G, B) are alternately arranged, and sub pixels of red, green, and blue by red, green, and blue semiconductor light emitting devices can form one pixel, and accordingly a full color display can be implemented.

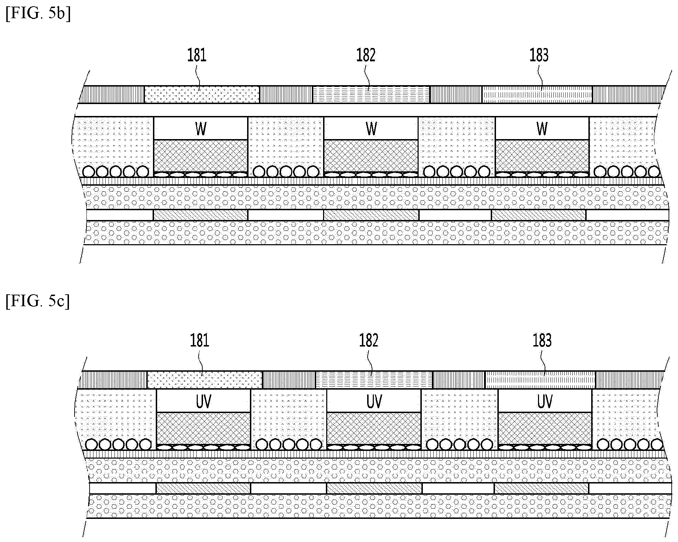

Referring to FIG. 5B, the semiconductor light emitting device may include a white light emitting device W in which a yellow phosphor layer is provided for each individual device. In this case, to form a unit pixel, a red phosphor layer 181, a green phosphor layer 182, and a blue phosphor layer 183 may be provided on the white light emitting device W. In addition, a unit pixel may be formed on the white light emitting device W by using a color filter in which red, green, and blue are repeated.

Referring to FIG. 5C, a structure in which a red phosphor layer 181, a green phosphor layer 182, and a blue phosphor layer 183 are provided on the ultraviolet light emitting device UV is also possible. In this way, the semiconductor light emitting device can be used not only for visible light but also for ultraviolet (UV) light, and the ultraviolet (UV) can be extended in the form of a semiconductor light emitting device that can be used as an excitation source of the upper phosphor.

Referring back to this example, the semiconductor light emitting device 150 can be positioned on the conductive adhesive layer 130 to constitute a unit pixel in the display device. Since the semiconductor light emitting device 150 has excellent luminance, individual unit pixels can be configured even with a small size. The individual semiconductor light emitting device 150 may have a side length of 80 µm or less, and may be a rectangular or square device. In the case of a rectangle, the size may be 20×80µm or less.

In addition, even when a square semiconductor light emitting device 150 having a side length of 10 µm is used as a unit pixel, sufficient brightness to form a display device can be exhibited. Accordingly, for example, when the size of the unit pixel is a rectangular pixel having one side of 600 µm and the other side of 300 µm, the distance of the semiconductor light emitting device is relatively large enough. Accordingly, in this case, it is possible to implement a flexible display device having a high quality higher than HD quality.

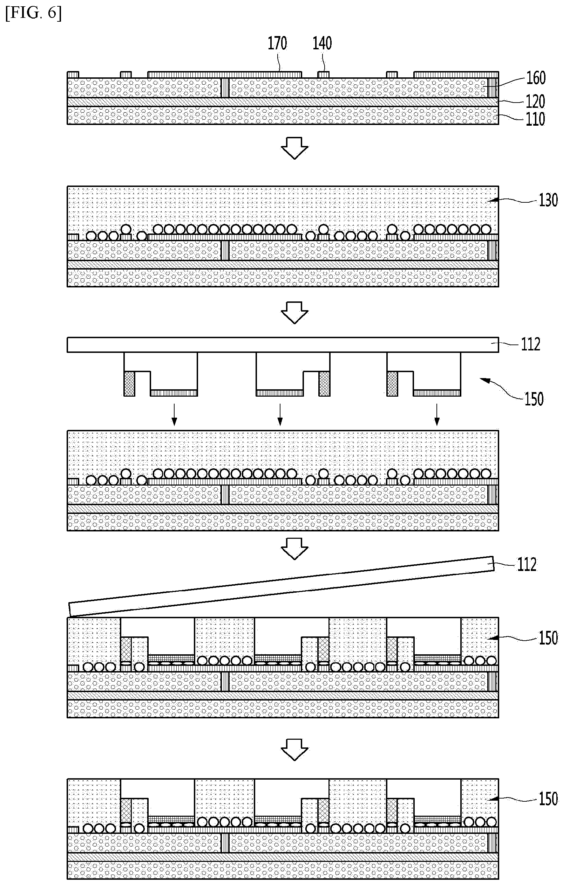

A display device using the semiconductor light emitting device described above can be manufactured by a new type of manufacturing method. Hereinafter, the manufacturing method will be described with reference to FIG. 6.

FIG. 6 is a cross-sectional view showing a method of manufacturing a display device using the semiconductor light emitting device of the present invention.

Referring to this drawing, first, a conductive adhesive layer 130 is formed on the insulating layer 160 on which the auxiliary electrode 170 and the second electrode 140 are positioned. An insulating layer 160 is stacked on the first substrate 110 to form one substrate (or wiring board), and the wiring substrate includes a first electrode 120, an auxiliary electrode 170, and a second electrode 140. In this case, the first electrode 120 and the second electrode 140 may be disposed in a mutually orthogonal direction. In addition, in order to implement a flexible display device, the first substrate 110 and the insulating layer 160 may each include glass or polyimide (PI).

The conductive adhesive layer 130 may be implemented by, for example, an anisotropic conductive film, and for this purpose, an anisotropic conductive film may be applied to a substrate on which the insulating layer 160 is positioned.

Next, the second substrate 112 on which the plurality of semiconductor light emitting devices 150 constituting individual pixels disposed to correspond to the positions of the auxiliary electrodes 170 and the second electrodes 140 are positioned above the semiconductor light emitting device 150 such that the semiconductor light emitting devices 150 face the auxiliary electrode 170 and the second electrode 140.

In this case, the second substrate 112 may be a growth substrate on which the semiconductor light emitting device 150 is grown, and may be a spire substrate or a silicon substrate.

When the semiconductor light emitting device is formed in a wafer unit, it can be effectively used in a display device by having an interval and a size capable of forming a display device.

Then, the wiring board and the second board 112 are thermally compressed. For example, the wiring board and the second board 112 may be hot pressed by applying an ACF press head. The wiring board and the second board 112 are bonded by the thermal compression bonding. Due to the property of the anisotropic conductive film having conductivity by thermocompression bonding, only the portion between the semiconductor light emitting device 150 and the auxiliary electrode 170 and the second electrode 140 has conductivity, through which electrodes and semiconductor light emitting device 150 may be electrically connected. At this time, the semiconductor light emitting device 150 is inserted into the anisotropic conductive film, through which a partition wall may be formed between the semiconductor light emitting devices 150.

Then, the second substrate 112 is removed. For example, the second substrate 112 may be removed using a laser lift-off method (LLO) or a chemical lift-off method (CLO).

Finally, the second substrate 112 is removed to expose the semiconductor light emitting devices 150 to the outside. If necessary, a transparent insulating layer (not shown) may be formed by coating a silicon oxide (SiOₓ) or the like on the wiring board to which the semiconductor light emitting device 150 is bonded.

In addition, a step of forming a phosphor layer on one surface of the semiconductor light emitting device 150 may be further included. For example, the semiconductor light emitting device 150 is a blue semiconductor light emitting device that emits blue (B) light, and a red or green phosphor for converting the blue (B) light into the color of a unit pixel can be formed as a layer on one side of the blue semiconductor light emitting device.

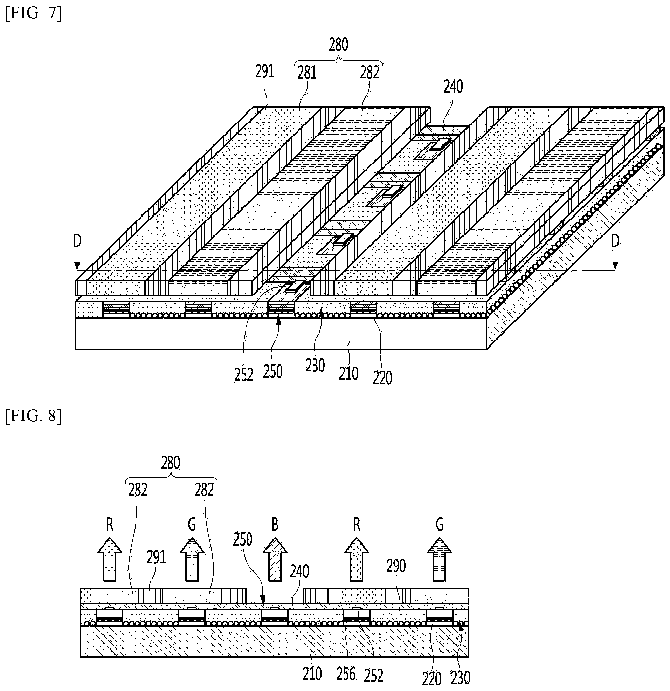

The manufacturing method or structure of a display device using the semiconductor light emitting device described above can be modified in various forms. As an example, a vertical semiconductor light emitting device may also be applied to the display device described above. Hereinafter, a vertical structure will be described with reference to FIGS. 7 and 8.

In addition, in the modified examples or embodiments described below, the same or similar reference numerals are assigned to the same or similar configurations as the previous example, and the description is replaced with the first description.

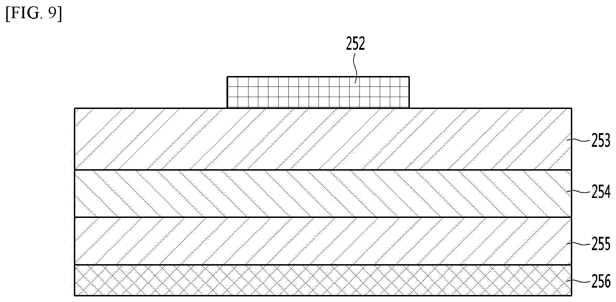

FIG. 7 is a perspective view showing another embodiment of a display device using the semiconductor light emitting device of the present invention, FIG. 8 is a cross-sectional view taken along line DD of FIG. 7, and FIG. 9 is a conceptual diagram showing a vertical semiconductor light emitting device of FIG. 8.

Referring to the drawings, the display device may be a display device using a passive matrix (PM) type vertical semiconductor light emitting device.

The display device may include a substrate 210, a first electrode 220, a conductive adhesive layer 230, a second electrode 240, and a plurality of semiconductor light emitting devices 250.

The substrate 210 is a wiring board on which the first electrode 220 is disposed, and may include polyimide (PI) to implement a flexible display device. In addition, any material that has insulation and is flexible may be used.

The first electrode 220 is positioned on the substrate 210 and may be formed as a long bar-shaped electrode in one direction. The first electrode 220 may be formed to serve as a data electrode.

The conductive adhesive layer 230 is formed on the substrate 210 on which the first electrode 220 is located. Like a display device to which a flip chip type light emitting element is applied, the conductive adhesive layer 230 is a solution containing an anisotropic conductive film (ACF), an anisotropic conductive paste, and conductive particles etc. However, the present embodiment also illustrates a case in which the conductive adhesive layer 230 is implemented by an anisotropic conductive film.

After placing the anisotropic conductive film on the substrate 210 with the first electrode 220 positioned, the semiconductor light emitting device 250 is connected by applying heat and pressure to the semiconductor and the light emitting device 250 can be electrically connected to the first electrode 220. In this case, the semiconductor light emitting device 250 is preferably disposed to be positioned on the first electrode 220.

As described above, the electrical connection is generated because it partially has conductivity in the thickness direction when heat and pressure are applied in the anisotropic conductive film. Accordingly, the anisotropic conductive film is divided into a conductive portion and a non-conductive portion in the thickness direction.

In addition, since the anisotropic conductive film contains an adhesive component, the conductive adhesive layer 230 implements electrical connection as well as mechanical coupling between the semiconductor light emitting device 250 and the first electrode 220.

As described above, the semiconductor light emitting device 250 is positioned on the conductive adhesive layer 230, thereby configuring individual pixels in the display device. Since the semiconductor light emitting device 250 has excellent luminance, individual unit pixels can be configured even with a small size. The individual semiconductor light emitting device 250 may have a side length of 80 µm or less, and may be a rectangular or square device. In the case of a rectangle, the size may be 20X80µm or less.

The semiconductor light emitting device 250 may have a vertical structure.

Between the vertical semiconductor light emitting devices, a plurality of second electrodes 240 can be disposed in a direction crossing the length direction of the first electrode 220 and electrically connected to the vertical semiconductor light emitting device 250.

Referring to FIG. 9, the vertical semiconductor light emitting device can include a p-type electrode 256, a p-type semiconductor layer 255 formed on the p-type electrode 256, an active layer 254 formed on the p-type semiconductor layer 255, an n-type semiconductor layer 253 formed on the active layer 254 and an n-type electrode 252 formed on the n-type semiconductor layer 253. In this case, the p-type electrode 256 located at the bottom may be electrically connected by the first electrode 220 and the conductive adhesive layer 230, and the n-type electrode 252 located at the top can be electrically connected by a second electrode 240 to be described later. The vertical semiconductor light emitting device 250 has a great advantage of reducing a chip size, since electrodes can be arranged up and down.

Referring back to FIG. 8, a phosphor layer 280 may be formed on one surface of the semiconductor light emitting device 250. For example, the semiconductor light emitting device 250 is a blue semiconductor light emitting device 251 that emits blue (B) light, and a phosphor layer 280 for converting the blue (B) light into a color of a unit pixel can be provided. In this case, the phosphor layer 280 may be a red phosphor 281 and a green phosphor 282 constituting individual pixels.

That is, at a position constituting a red unit pixel, a red phosphor 281 capable of converting blue light into red (R) light may be stacked on a blue semiconductor light emitting device, and at a position constituting a green unit pixel, a green phosphor 282 capable of converting blue light into green (G) light may be stacked on the blue semiconductor light emitting device. In addition, only a blue semiconductor light emitting device may be used alone in a portion constituting a blue unit pixel. In this case, unit pixels of red (R), green (G), and blue (B) may form one pixel.

However, the present invention is not necessarily limited thereto, and other structures for implementing blue, red, and green colors may be applied as described above in a display device to which a flip chip type light emitting device is applied.

Referring back to this embodiment, the second electrode 240 is positioned between the semiconductor light emitting devices 250 and is electrically connected to the semiconductor light emitting devices 250. For example, the semiconductor light emitting devices 250 may be arranged in a plurality of rows, and the second electrode 240 may be located between rows of the semiconductor light emitting devices 250.

Since the distance between the semiconductor light emitting devices 250 constituting individual pixels is sufficiently large, the second electrode 240 may be positioned between the semiconductor light emitting devices 250.

The second electrode 240 may be formed as a long bar-shaped electrode in one direction, and may be disposed in a direction perpendicular to the first electrode.

In addition, the second electrode 240 and the semiconductor light emitting device 250 may be electrically connected by a connection electrode protruding from the second electrode 240. More specifically, the connection electrode may be an n-type electrode of the semiconductor light emitting device 250. For example, the n-type electrode is formed as an ohmic electrode for ohmic contact, and the second electrode covers at least a part of the ohmic electrode by printing or vapor deposition. Through this, the second electrode 240 and the n-type electrode of the semiconductor light emitting device 250 may be electrically connected.

As shown in the drawing, the second electrode 240 may be positioned on the conductive adhesive layer 230. In some cases, a transparent insulating layer (not shown) including silicon oxide (SiOx) or the like may be formed on the substrate 210 on which the semiconductor light emitting device 250 is formed. When the second electrode 240 is positioned after the transparent insulating layer is formed, the second electrode 240 is positioned on the transparent insulating layer. In addition, the second electrode 240 may be formed to be spaced apart from the conductive adhesive layer 230 or the transparent insulating layer.

If a transparent electrode such as ITO (Indium Tin Oxide) is used to position the second electrode 240 on the semiconductor light emitting device 250, the ITO material has poor adhesion to the n-type semiconductor layer. Accordingly, according to the present invention, since the second electrode 240 is positioned between the semiconductor light emitting devices 250, there is an advantage in that a transparent electrode such as ITO is not required. Therefore, the light extraction efficiency can be improved by using an n-type semiconductor layer and a conductive material having good adhesion as a horizontal electrode without being restricted by the selection of a transparent material.

According to the illustration, a partition wall 290 may be positioned between the semiconductor light emitting devices 250. That is, the partition wall 290 may be disposed between the vertical semiconductor light emitting devices 250 to isolate the semiconductor light emitting devices 250 constituting individual pixels. In this case, the partition wall 290 may serve to separate individual unit pixels from each other, and may be integrally formed with the conductive adhesive layer 230. For example, when the semiconductor light emitting device 250 is inserted into the anisotropic conductive film, the base member of the anisotropic conductive film may form the partition wall.

In addition, if the base member of the anisotropic conductive film is black, the partition wall 290 may have reflective properties and increase contrast even without a separate black insulator.

As another example, as the partition wall 190, a reflective partition wall may be separately provided. The partition wall 290 may include a black or white insulator depending on the purpose of the display device.

If the second electrode 240 is directly positioned on the conductive adhesive layer 230 between the semiconductor light emitting devices 250, the partition wall 290 can be located between the vertical semiconductor light emitting device 250 and the second electrode 240. Accordingly, individual unit pixels can be configured with a small size using the semiconductor light emitting device 250, and the distance of the semiconductor light emitting device 250 is relatively large enough to connect the second electrode 240 , there is an effect of implementing a flexible display device having HD image quality.

Further, according to the illustration, a black matrix 291 may be disposed between each phosphor to improve contrast. That is, the black matrix 291 can improve contrast of light and dark.

As described above, the semiconductor light emitting device 250 is positioned on the conductive adhesive layer 230, thereby configuring individual pixels in the display device. Since the semiconductor light emitting device 250 has excellent luminance, individual unit pixels can be configured even with a small size. Accordingly, a full color display in which unit pixels of red (R), green (G), and blue (B) form one pixel may be implemented by the semiconductor light emitting device.

Meanwhile, in the case of a display using the above-described semiconductor light emitting device, in order to increase the resolution, the size of the semiconductor light emitting device must be miniaturized to within several to tens of micrometers.

The size of the light emitting portion of the semiconductor light emitting device may be defined through dry etching in a vertical direction. Accordingly, an etching surface of each layer may exist on the side of the outer portion of the device exposed through dry etching. An unstable surface state having an energy level lower than that of the semiconductor band gap may exist on the surface of the etched surface or inside the semiconductor layer adjacent to the surface. Due to the unstable surface state, non-luminescent recombination between electrons and holes occurs in the outer portion of the device, which may reduce the efficiency of light-emitting recombination emitted from the active layer.

The range in which the non-luminescent recombination at the outer part of the device affects is about several micrometers. As the device becomes smaller, the influence of the non-luminescent recombination may increase. Further, as the device becomes smaller, the current supplied to the device may decrease, but when the supplied current decreases, the frequency of the non-emission recombination may increase. As a result, the internal quantum efficiency of the micro-semiconductor light emitting device rapidly decreases.

In order to solve the above-described problem, the semiconductor light emitting device according to an embodiment of the present invention may form a trench structure in a vertical direction in the semiconductor layer above the active layer, and metal nanoparticles may be inserted into the trench.

In this case, surface plasmon resonance between the light generated in the active layer and the metal nanoparticles may occur. The surface plasmon may be a surface electromagnetic wave that collectively vibrates under the influence of light by free electrons existing on the surface of the metal, causing resonance in a local region at the boundary between the metal and the dielectric.

Such surface electromagnetic waves are sufficiently close to the active layer existing inside the semiconductor light emitting device, and energy coupling may occur when the vibration energy of the free electrons on the metal surface and the vibration energy of the electromagnetic wave are matched. In this case, energy coupling occurs not only for luminescent recombination energy but also for non-luminescent recombination energy to increase luminescent recombination, thereby increasing internal quantum efficiency.

In order to increase light emission recombination due to the surface plasmon resonance, the distance between the active layer and the metal nanoparticles should be formed close to tens of nanometers or less.

In this regard, a structure in which the metal nanoparticles are formed on the semiconductor layer stacked on the active layer may be easy when manufacturing the semiconductor light emitting device. However, there is a problem that excitation of surface plasmon resonance is not easy due to the thickness limit of the semiconductor layer.

Alternatively, a structure in which metal nanoparticles are embedded in the semiconductor layer may be considered. However, this structure has disadvantages in terms of process reproducibility and characteristics deterioration due to the problems such as increasing the process time, the bad quality of the semiconductor layer, and the exposure of the metal nanoparticles to the high temperature environment owing to the semiconductor layer stacking process through a high-temperature growth method such as MOCVD.

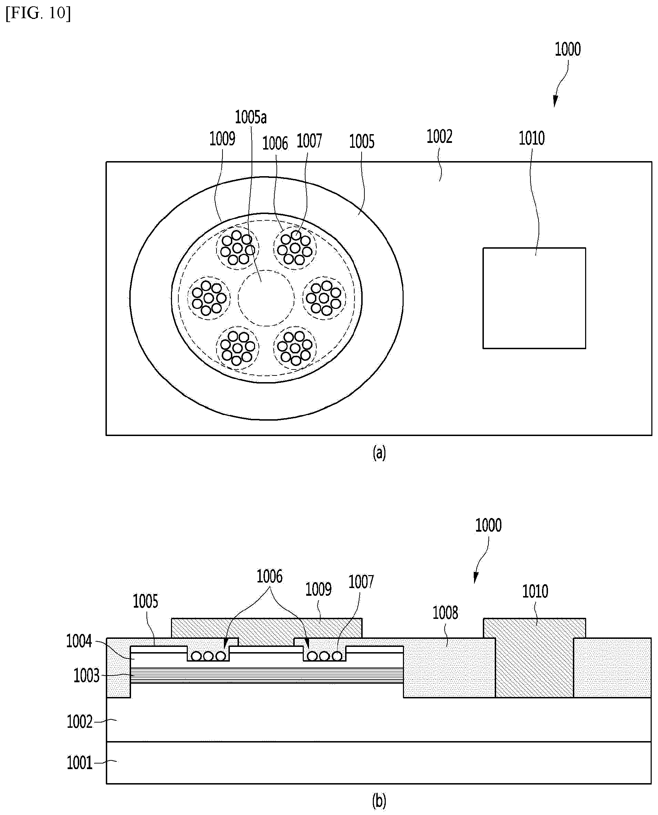

Hereinafter, embodiments related to a structure of a semiconductor light emitting device having a trench structure and metal nanoparticles for solving the above-described problems will be described with reference to FIGS. 10 to 14.

The semiconductor light emitting device shown in FIGS. 10 to 14 corresponds to a structure in a state before being bonded to the wiring board described above in FIG. 2 and the like.

Meanwhile, in FIGS. 10 to 14 below, a horizontal direction is defined as a lateral direction and a perpendicular direction is defined as a vertical direction based on a cross-sectional view.

FIG. 10 is a diagram illustrating a structure of a semiconductor light emitting device according to an embodiment of the present invention.

Referring to FIGS. 10A and 10B, the semiconductor light emitting device 1000 includes a growth substrate 1001 and a first conductivity type semiconductor layer 1002 (for example, n Type semiconductor layer) formed on the growth substrate 1001; an active layer 1003 formed on the first conductivity type semiconductor layer 1002, and a second conductivity type semiconductor layer 1004 formed on the active layer 1003 (for example, a p-type semiconductor layer).

The growth substrate 1001 corresponds to a substrate for growth of the semiconductor layers 1002 and 1004 and the active layer 1003. For example, the growth substrate 1001 may be implemented as a sapphire substrate, but is not limited thereto. The growth substrate 1001 may be removed after the semiconductor light emitting device 1000 is later bonded to the wiring board. This has been described above in FIG. 6.

On the growth substrate 1001, a first conductivity type semiconductor layer 1002, an active layer 1003, and a second conductivity type semiconductor layer 1004 may be sequentially stacked. For example, the first conductivity type semiconductor layer 1002, the active layer 1003, and the second conductivity type semiconductor layer 1004 may be formed through a nitride-based semiconductor growth method such as Metal-Organic Chemical Vapor Deposition (MOCVD), but it is not limited thereto.

The semiconductor light emitting device 1000 should emit visible light when electrons and holes are recombined. Silicon or germanium, which are common materials used in semiconductor manufacturing, emit heat when electrons and holes are recombined due to an indirect bandgap, but do not emit visible light. Accordingly, according to an embodiment of the present invention, the semiconductor layers 1002 and 1004 and the active layer 1003 may be formed of a material such as gallium nitride (GaN), gallium arsenide (GaAs), or gallium phosphide (GaP).

The first conductivity type semiconductor layer 1002 and the second conductivity type semiconductor layer 1004 may have characteristics according to impurities mixed in the above-described material (GaN, GaAs, or GaP). For example, the first conductivity-type semiconductor layer 1002 may be formed as an n-type semiconductor layer as impurities (donors) such as silicon (Si) are mixed. In addition, the second conductivity-type semiconductor layer 1004 may be formed as a p-type semiconductor layer as impurities (acceptors) such as magnesium (Mg) are mixed.

As current is applied to the semiconductor light emitting device 1000, electrons may be emitted from the first conductivity type semiconductor layer 1002 and holes may be emitted from the second conductivity type semiconductor layer 1004. As the emitted electrons and holes recombine in the active layer, the energy level may be lowered. As the energy level decreases, energy can be released in the form of light or heat. As the light is emitted, the semiconductor light emitting device 1000 may emit light.

According to an embodiment, a second conductivity type semiconductor high concentration doped layer 1005 may be further stacked on the second conductivity type semiconductor layer 1004. The second conductivity type semiconductor high concentration doped layer 1005 may have the same polarity as the second conductivity type semiconductor layer 1004. The second conductivity type semiconductor high concentration doped layer 1005 may compensate for a decrease in electrical characteristics of the second conductivity type semiconductor layer 1004 due to the formation of a trench 1006 to be described later.

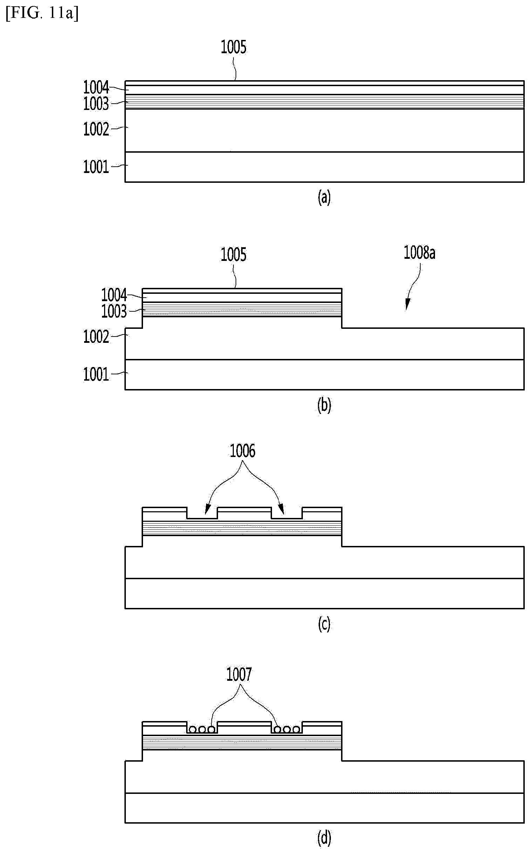

Referring to FIG. 10B, the active layer 1003 and the second conductivity type semiconductor layer 1004 may be stacked on a partial region of the first conductivity type semiconductor layer 1002. As will be described later in FIG. 11A, this structure can be formed by a mesh etching process of removing a region other than the partial region of the active layer 1003, the second conductivity-type semiconductor layer 1004, and the first conductivity-type semiconductor layer 1002.

In this case, a region in which the mesa etching process is not performed, that is, a region in which the active layer 1003, the second conductivity type semiconductor layer 1004, and the second conductivity type semiconductor high concentration doped layer 1005 remain through the mesa etching process can be defined as a mesa region. The mesa region defined through the mesa etching process may have various shapes such as a circle, a square, a triangle, and a hexagon when the semiconductor light emitting device 1000 is viewed on a plane. In this description, it is assumed that the mesa region is formed in a circular shape for convenience of describing.

As the mesa etching process is performed, a side surface (etched surface) of the mesa region may be formed. In this case, an unstable surface state having an energy level lower than that of the semiconductor band gap may exist on the surface of the active layer 1003 exposed to the etch surface or an active layer region adjacent to the etch surface. Due to the unstable surface state, non-luminescent recombination between electrons and holes may occur in the etching surface or in a region adjacent to the etching surface, and as a result, the internal quantum efficiency of the semiconductor light emitting device 1000 may be reduced.

In an embodiment of the present invention, a trench 1006 may be formed in a partial region of the second conductivity type semiconductor layer 1004 and the second conductivity type semiconductor high concentration doped layer 1005 to prevent the internal quantum efficiency from deteriorating.

The trench 1006 may have various shapes depending on the area to be etched. For example, as shown in FIG. 10A, the trench 1006 may be formed to have a plurality of circular shapes on a plane.

Meanwhile, in order to prevent a decrease in internal quantum efficiency due to damage to the active layer 1003 during the trench formation process, a bottom surface of the trench 1006 may be located in the second conductivity type semiconductor layer 1004. That is, a depth from a surface of the second conductivity type semiconductor layer 1004 (or a surface of the second conductivity type semiconductor high concentration doped layer 1005) to a bottom surface of the trench 1006 can be less than a thickness of the second conductivity type semiconductor layer 1004(or a sum of a thicknesses of the second conductivity-type semiconductor high concentration doped layer 1005 and the second conductivity-type semiconductor layer 1004).

According to an embodiment, in order to effectively generate the above-described surface plasmon resonance, the distance between the bottom surface of the trench 1006 and the active layer 1003 may be 100 nanometers or less, but is not limited thereto. Alternatively, the bottom surface of the trench 1006 may be positioned closer to the upper surface of the active layer 1003 than the surface of the second conductivity type semiconductor layer 1004.

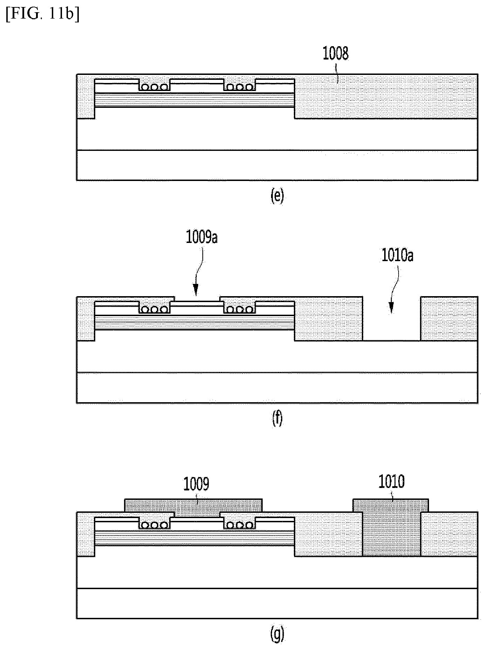

Meanwhile, a trench may not be formed in the central portion 1005a of the mesa region. In addition, during the electrode formation process as shown in FIG. 11B(g) later, the second electrode 1009 may be formed to come into contact with at least a portion of the central portion 1005a.

Accordingly, when the semiconductor light emitting device 1000 is driven, the flow of current may be concentrated to the central portion 1005a of the mesa region. As a result, since the amount of current flowing to the etched surface of the mesa region decreases, the frequency of non-emission surface recombination between electrons and holes occurring in the etched surface may be reduced.

Meanwhile, a distance between an outer surface of the central portion 1005a of the mesa region and the etching surface may be determined as a distance at which luminous efficiency is maximized. When the distance between the outer surface of the center 1005a and the etched surface is short, suppression of recombination of the non-luminescent surface may be insufficient. On the other hand, when the distance between the outer surface of the central portion 1005a and the etched surface is long, the area of the central portion 1005a is reduced, and thus the light output may decrease due to a decrease in the light emitting area. For example, the distance between the outer surface of the center 1005a and the etching surface may be about 1 micrometer to 5 micrometers, but is not limited thereto.

A metal member (in accordance with the invention, metal nanoparticles 1007) is inserted into the trench 1006. The metal nanoparticle 1007 may include silver (Ag), aluminum (Al), or gold (Au), but is not limited thereto. For example, the metal nanoparticles 1007 may have a diameter of 10 nanometers to 100 nanometers, and may have a shape of a sphere or a core-shell. When the metal nanoparticles 1007 have a core-shell shape, an insulating film such as silica may be implemented in a structure surrounding a sphere of metal.

Meanwhile, in an example not forming part of the claimed invention, a metal thin film may be inserted into the trench 1006 instead of the metal nanoparticle 1007, but in the case of the metal thin film, the condition under which surface plasmon resonance is excited is limited compared to the metal nanoparticle 1007. In addition, in the case of a metal thin film, since light emitted from the active layer 1003 can be blocked from being emitted to the outside, the light efficiency may be lowered. Therefore, it may be appropriate to insert the metal nanoparticles 1007 into the trench 1006.

As the metal nanoparticles 1007 are inserted into the trench 1006, the metal nanoparticles 1007 may be accommodated in the bottom surface of the trench 1006. The closer the bottom surface of the trench 1006 is to the upper surface of the active layer 1003, the closer the distance between the metal nanoparticles 1007 and the active layer 1003 is, and the surface plasma resonance can be made more effectively.

Since the life of the conductive electrons or holes is reduced by the surface plasmon resonance, the conductive electrons or holes are recombined before moving from the center 1005a to the etching surface, thereby increasing the probability of light emission recombination, and the probability of non-luminescence recombination can be reduced.

The semiconductor light emitting device 1000 further includes a passivation insulating layer 1008 covering the semiconductor layers 1002 and 1004, the active layer 1003, and the second conductivity type semiconductor high concentration doped layer 1005 exposed thereon. For example, the passivation insulating layer 1008 may be made of a material such as transparent silica (silicon dioxide) or alumina. The passivation insulating layer 1008 may have a thickness of 1 nanometer to 100 nanometers, but is not limited thereto.

Electrodes 1009 and 1010 may be formed on the passivation insulating layer 1008. The first electrode 1010 and the second electrode 1009 are formed to be spaced apart from each other in a horizontal direction. The first electrode 1010 and the second electrode 1009 may be implemented as a transparent electrode (eg, indium tin oxide, ITO).

For example, the first electrode 1010 (eg, a cathode electrode) is connected to the first conductivity type semiconductor layer 1002, and the second electrode 1009 (eg, an anode electrode) is connected to the second conductivity type semiconductor layer 1004 or the second conductivity type semiconductor high concentration doped layer 1005. For this structure, a portion of the passivation insulating layer 1008 on the second conductivity type semiconductor layer 1004 or the second conductivity type semiconductor high concentration doped layer 1005 may be etched. In this case, in order to connect the second electrode 1009 to the central portion 1005a, a region of the passivation insulating layer 1008 corresponding to the central portion 1005a may be etched. In addition, a partial region of the passivation insulating layer 1008 on the first conductivity type semiconductor layer 1002 may be etched.

The first electrode 1010 may be connected to be in contact with the first conductivity type semiconductor layer 1002 through an etched region on the first conductivity type semiconductor layer 1002. The second electrode 1009 may be in contact with the second conductivity type semiconductor layer 1004 or the second conductivity type semiconductor high concentration doped layer 1005 through an etched region of the second conductivity type semiconductor layer 1004 or the second conductivity type semiconductor high concentration doped layer 1005.

Hereinafter, a method of manufacturing the semiconductor light emitting device 1000 illustrated in FIG. 10 will be described with reference to FIGS. 11A to 11B.

FIGS. 11A to 11B are cross-sectional views illustrating a method of manufacturing a semiconductor light emitting device according to the embodiment illustrated in FIG. 10.

Referring to FIG. 11A(a), a first conductivity type semiconductor layer 1002, an active layer 1003, and a second conductivity type semiconductor layer 1004 are sequentially stacked on the growth substrate 1001. A semiconductor layer growth process may be performed.

For example, the first conductivity type semiconductor layer 1002, the active layer 1003, and the second conductivity type semiconductor layer 1004 can be formed through a nitride-based semiconductor growth method such as Metal-Organic Chemical Vapor Deposition (MOCVD), but is not limited thereto.

According to the invention, a second conductivity type semiconductor high concentration doped layer 1005 is further stacked on the second conductivity type semiconductor layer 1004. The second conductivity type semiconductor high concentration doped layer 1005 may have the same polarity as the second conductivity type semiconductor layer 1004. The second conductivity type semiconductor high concentration doped layer 1005 may compensate for a decrease in electrical characteristics of the second conductivity type semiconductor layer 1004 due to the formation of a trench 1006 to be described later.

Referring to FIG. 11A(b), after the semiconductor layer growth process is performed, a mesa etching process may be performed using a dry etching exposing the first conductivity type semiconductor layer 1002 in a vertical direction in a partial region 1008a of the semiconductor light emitting device 1000. Accordingly, an electrode may be formed in the first conductivity type semiconductor layer 1002 to inject current.

In this case, a remained region by the mesa etching process to the active layer 1003, the second conductivity-type semiconductor layer 1004, and the second conductivity-type semiconductor high-concentration doped layer 1005 can be defined as a mesa region.

The mesa region defined through the mesa etching process may have various shapes such as a circle, a square, a triangle, and a hexagon when the semiconductor light emitting device 1000 is viewed on a plane.

Referring to FIG. 11A(c), after the mesa etching process is performed, a trench formation process of forming a trench 1006 by dry etching a portion of the mesa region may be performed. The trench 1006 may have various shapes depending on an area to be etched. For example, in the embodiment of FIG. 10, the trench 1006 may be formed to have a plurality of circular shapes on a plane.

As described above with reference to FIG. 10, the trench 1006 may be formed such that the bottom surface is positioned within the second conductivity type semiconductor layer 1004. That is, the depth from the surface of the second conductivity type semiconductor layer 1004 (or the surface of the second conductivity type semiconductor high concentration doping layer 1005) to the bottom surface of the trench 1006 is less than the thickness of the second conductivity type semiconductor layer 1004(or the sum of the thicknesses of the second conductivity-type semiconductor high concentration doping layer 1005 and the second conductivity-type semiconductor layer 1004).

According to an embodiment, in order to effectively generate surface plasmon resonance, a distance between the bottom surface of the trench 1006 and the active layer 1003 may be 100 nanometers or less, but is not limited thereto.

Meanwhile, during the trench formation process, a trench is not formed in the central portion 1005a of the mesa region.

According to an embodiment, the mesa etching process shown in FIG. 11A(b) and the trench formation process shown in FIG. 11A(c) may be simultaneously performed.

Referring to FIG. 11A(d), after the trench formation process is performed, a process of inserting a metal member (metal nanoparticle 1007) into the trench 1006 may be performed. The insertion process of the metal nanoparticles 1007 includes a process of dropping a solution in which the metal nanoparticles 1007 such as silver (Ag), aluminum (Al), gold (Au) are mixed with a solvent such as isopropyl alcohol, ethylene glycol, sodium citrate, into the trench 1006. In addition, the process of inserting the metal nanoparticles 1007 may include a process of precipitating the metal nanoparticles 1007 contained in the colloid dropped into the trench 1006 and drying (or evaporating) the solvent.

Referring to FIG. 11B(e), after the metal nanoparticles 1007 are inserted into the trench 1006, a process of forming a passivation insulating layer 1008 capable of covering exposed structure of the semiconductor layers 1002 and 1004, the active layer 1003, the second conductivity type semiconductor high concentration doping layer 1005 and the metal nanoparticles 1007 can be performed.

The passivation insulating layer 1008 is formed by using an inorganic insulator such as silica and alumina through PECVD (Plasma Enhanced Chemical Vapor Deposition), LPCVD (Low Pressure CVD), sputtering deposition, or a photoresist or may be formed through a method of spin coating an organic material such as a polymer material.

Referring to FIG. 11B(f)and FIG. 11B(g), a passivation etching process in which the passivation insulating layer 1008 is dry-etched can be performed such that a portion of the surface of the first conductivity type semiconductor layer 1002 and the second conductivity type semiconductor layer 1004 (or the second conductivity type semiconductor high concentration doped layer 1005) can be exposed.

After the passivation etching process is performed, an electrode forming process of forming the first electrode 1010 and the second electrode 1009 may be performed. The electrode formation process may be performed through E-beam evaporation or sputtering deposition.

As described above with reference to FIG. 10, the second electrode 1009 is formed to be connected to at least a portion of the central portion 1005a, so that the flow of current may be concentrated to the central portion 1005a of the mesa region.

To this end, a passivation etching process is performed so that at least a part of the central portion 1005a of the surface of the second conductivity type semiconductor layer 1004(or the second conductivity type semiconductor high concentration doped layer 1005) can be exposed.

That is, according to the embodiment of the present invention, the semiconductor light emitting device 1000 can suppress non-luminescent recombination of the semiconductor light emitting device 1000 through surface plasmon resonance between the light generated in the active layer 1003 and the metal nanoparticles 1007. Thus, the internal quantum efficiency can be improved.

In particular, the semiconductor light emitting device 1000 can minimize the distance between the metal nanoparticles 1007 and the active layer 1003 through a trench structure formed in the second conductivity type semiconductor layer 1004, through which surface plasmon resonance effect can be maximized. Accordingly, the internal quantum efficiency of the semiconductor light emitting device 1000 may be more effectively improved.

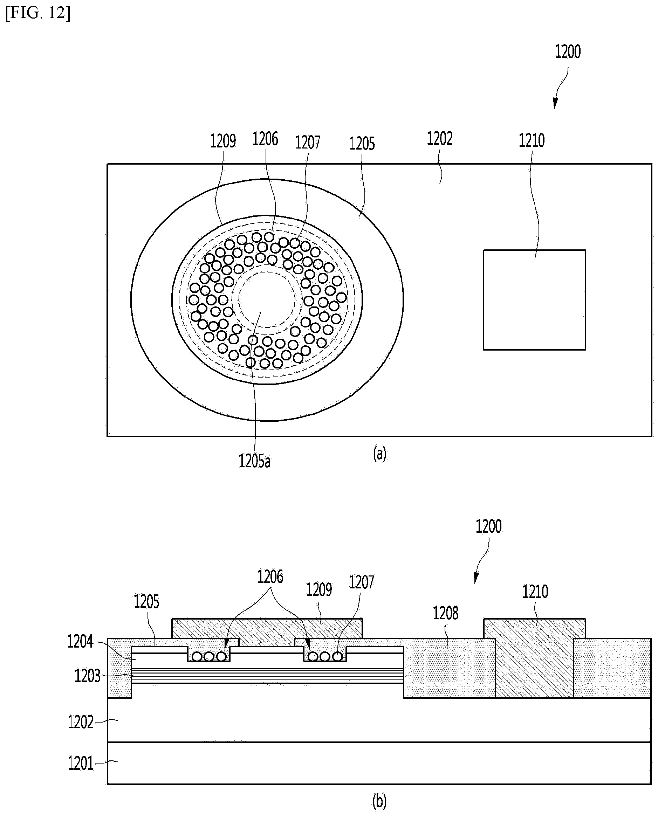

FIGS. 12 to 14 are diagrams illustrating a structure of a semiconductor light emitting device according to various embodiments of the present disclosure.

In FIGS. 12 to 14, each of the semiconductor light emitting devices 1200, 1300, and 1400 can be similar to the semiconductor light emitting device 1000 shown in FIG. 10 except for the trenches 1206, 1306, 1406a, and 1406b.

Referring to FIGS. 12 to 14, trenches 1206, 1306, 1406a, and 1406b having various shapes may be formed in the second conductivity type semiconductor layer 1004 of the semiconductor light emitting devices 1200, 1300, and 1400.

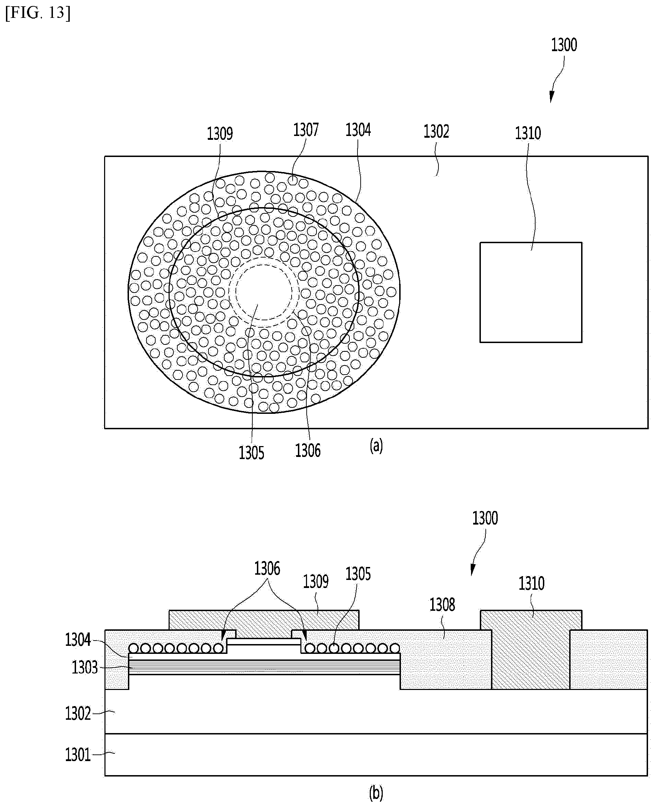

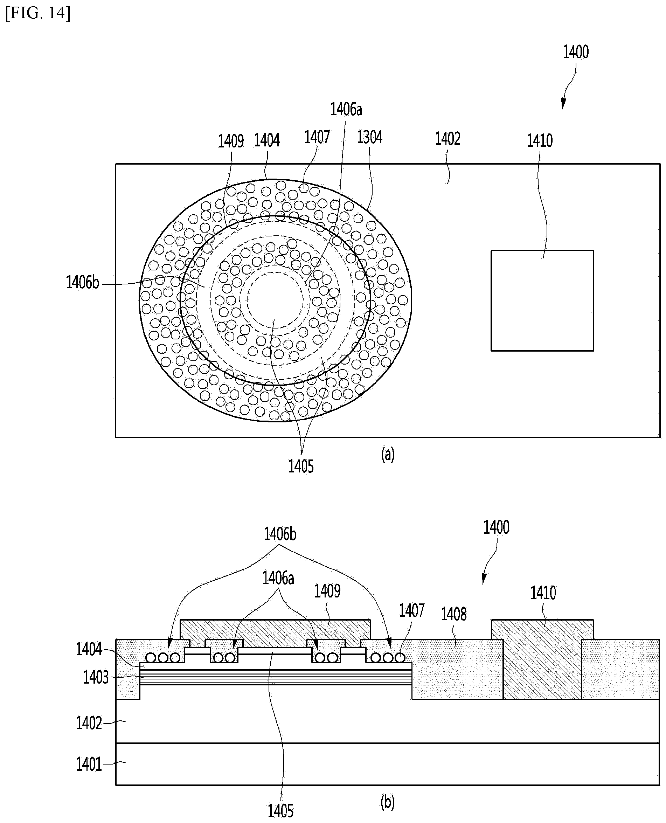

As shown in FIG. 12, the trench 1206 according to the embodiment may be formed in a ring shape spaced apart from the etching surface. In addition, as in the embodiment illustrated in FIG. 13, the trench 1306 may be formed in the rest area except for the central portion 1305a. Meanwhile, as in the embodiment illustrated in FIG. 14, a plurality of trenches 1406a and 1406b may be formed in a concentric circle shape. However, in addition to the embodiments illustrated in FIGS. 12 to 14, the trench may be formed in various shapes.

On the other hand, in the embodiment of FIGS. 12 to 14 as well as the embodiment of FIG. 10, since trenches are not formed in the centers 1205a, 1305a, 1405, the occurrence of non-luminescent recombination on the etched surface can be effectively suppressed.

The above description is merely illustrative of the technical idea of the present invention, and those of ordinary skill in the technical field to which the present invention pertains can make various modifications and variations without departing from the scope of the invention as claimed.

Accordingly, the embodiments disclosed in the present invention are not intended to limit the technical idea of the present invention, but to explain the technical idea, and the scope of the technical idea of the present invention is not limited by these embodiments.

The scope of protection of the present invention is defined by the following claims only.

## Claims

1. A semiconductor light emitting device comprising:
a growth substrate (1001);
a first conductivity type semiconductor layer (1002) formed on the growth substrate;
an active layer (1003) formed in a partial region on the first conductivity type semiconductor layer (1002);
a second conductivity type semiconductor layer (1004) formed on the active layer (1003);
a trench (1006) formed by etching a portion of a top surface of the second conductivity type semiconductor layer (1004); a second conductivity type semiconductor high concentration doped layer (1005) formed on the second conductivity type semiconductor layer (1004), wherein the trench (1006) is etched from a partial region of the surface of the second conductivity type semiconductor high concentration doped layer (1005),
a plurality of metal nanoparticles (1007) inserted into the trench;
wherein the trench (1006) is formed in a region spaced apart from a central portion of the surface of the second conductivity type semiconductor layer (1004);
a first electrode (1010) connected to the first conductivity type semiconductor layer; a second electrode (1009) spaced apart from the first electrode (1010) and connected to the second conductivity type semiconductor layer (1004) or the second conductivity type semiconductor high concentration doped layer (1005);
wherein the second electrode (1009) is connected to be in contact with the central portion of the surface of the second conductivity type semiconductor layer (1004) or the second conductivity type semiconductor high concentration doped layer (1005); and
a passivation insulating layer (1008) disposed between the metal nanoparticles (1007) and the second electrode (1009), the passivation layer covering the first and second semiconductor layers (1002, 1004), the active layer (1003), and the second conductivity type semiconductor high concentration doped layer (1005) exposed thereon.

2. The semiconductor light emitting device according to claim 1, wherein the first electrode and the second electrode are implemented as transparent electrodes.

3. The semiconductor light emitting device according to claim 1, wherein a depth from a surface of the second conductivity type semiconductor layer to a bottom surface of the trench is smaller than a thickness of the second conductivity type semiconductor layer.

4. The semiconductor light emitting device according to claim 3, wherein the bottom surface of the trench is positioned closer to an upper surface of the active layer than the surface of the second conductivity type semiconductor layer.

5. The semiconductor light emitting device according to claim 1, wherein the metal nanoparticles comprise at least one of silver, aluminum, or gold.

6. The semiconductor light emitting device according to claim 1, wherein the second conductivity type semiconductor high concentration doped layer is positioned higher than the metal nanoparticles.

7. The semiconductor light emitting device according to claim 1, wherein the second electrode is directly disposed on the second conductivity type semiconductor high concentration doped layer disposed between the trenches.

8. The semiconductor light emitting device according to claim 1, wherein a plurality of trenches is formed in a concentric circle shape,
wherein the concentric circle shape trenches comprise a first concentric circle shape trench and a second concentric circle shape trench spaced apart and surrounding the first concentric circle shape trench.

9. A display device comprising the semiconductor light emitting device according to claim 1.

## Patentansprüche

1. Halbleiter-Lichtemissionsvorrichtung, aufweisend:
ein Wachstumssubstrat (1001);
eine Halbleiterschicht eines ersten Leitfähigkeitstyps (1002), die auf dem Wachstumssubstrat ausgebildet ist;
eine aktive Schicht (1003), die in einem Teilbereich auf der Halbleiterschicht des ersten Leitfähigkeitstyps (1002) ausgebildet ist;
eine Halbleiterschicht eines zweiten Leitfähigkeitstyps (1004), die auf der aktiven Schicht (1003) ausgebildet ist;
einen Graben (1006), der durch Ätzen eines Abschnitts einer oberen Oberfläche der Halbleiterschicht des zweiten Leitfähigkeitstyps (1004) ausgebildet ist;
eine hochkonzentriert dotierte Halbleiterschicht des zweiten Leitfähigkeitstyps (1005), die auf der Halbleiterschicht des zweiten Leitfähigkeitstyps (1004) ausgebildet ist, wobei der Graben (1006) aus einem Teilbereich der Oberfläche der hochkonzentriert dotierten Halbleiterschicht des zweiten Leitfähigkeitstyps (1005) herausgeätzt ist,
eine Mehrzahl von Metallnanopartikeln (1007), die in den Graben eingebracht sind;
wobei der Graben (1006) in einem Bereich ausgebildet ist, der von einem zentralen Abschnitt der Oberfläche der Halbleiterschicht des zweiten Leitfähigkeitstyps (1004) beabstandet ist;
eine erste Elektrode (1010), die mit der Halbleiterschicht des ersten Leitfähigkeitstyps verbunden ist;
eine zweite Elektrode (1009), die von der ersten Elektrode (1010) beabstandet und mit der Halbleiterschicht des zweiten Leitfähigkeitstyps (1004) oder der hochkonzentriert dotierten Halbleiterschicht des zweiten Leitfähigkeitstyps (1005) verbunden ist;
wobei die zweite Elektrode (1009) so verbunden ist, dass sie mit dem zentralen Abschnitt der Oberfläche der Halbleiterschicht des zweiten Leitfähigkeitstyps (1004) oder der hochkonzentriert dotierten Halbleiterschicht des zweiten Leitfähigkeitstyps (1005) in Kontakt steht; und
eine Passivierungsisolierschicht (1008), die zwischen den Metallnanopartikeln (1007) und der zweiten Elektrode (1009) angeordnet ist, wobei die Passivierungsschicht die erste und die zweite Halbleiterschicht (1002, 1004), die aktive Schicht (1003) und die darauf freiliegende hochkonzentriert dotierte Halbleiterschicht des zweiten Leitfähigkeitstyps (1005) bedeckt.

2. Halbleiter-Lichtemissionsvorrichtung gemäß Anspruch 1, wobei die erste Elektrode und die zweite Elektrode als transparente Elektroden ausgeführt sind.

3. Halbleiter-Lichtemissionsvorrichtung gemäß Anspruch 1, wobei eine Tiefe von einer Oberfläche der Halbleiterschicht des zweiten Leitfähigkeitstyps bis zu einer Bodenfläche des Grabens kleiner ist als eine Dicke der Halbleiterschicht des zweiten Leitfähigkeitstyps.

4. Halbleiter-Lichtemissionsvorrichtung gemäß Anspruch 3, wobei die Bodenfläche des Grabens näher an einer oberen Oberfläche der aktiven Schicht positioniert ist als die Oberfläche der Halbleiterschicht des zweiten Leitfähigkeitstyps.

5. Halbleiter-Lichtemissionsvorrichtung gemäß Anspruch 1, wobei die Metallnanopartikel mindestens eines der Materialien Silber, Aluminium oder Gold aufweisen.

6. Halbleiter-Lichtemissionsvorrichtung gemäß Anspruch 1, wobei die hochkonzentriert dotierte Halbleiterschicht des zweiten Leitfähigkeitstyps höher als die Metallnanopartikel positioniert ist.

7. Halbleiter-Lichtemissionsvorrichtung gemäß Anspruch 1, wobei die zweite Elektrode direkt auf der hochkonzentriert dotierten Halbleiterschicht des zweiten Leitfähigkeitstyps angeordnet ist, die zwischen den Gräben angeordnet ist.

8. Halbleiter-Lichtemissionsvorrichtung gemäß Anspruch 1, wobei eine Mehrzahl von Gräben in Form konzentrischer Kreise ausgebildet ist, wobei die Gräben in Form konzentrischer Kreise einen ersten Graben in Form eines konzentrischen Kreises und einen zweiten Graben in Form eines konzentrischen Kreises aufweisen, der beabstandet ist und den ersten Graben in Form eines konzentrischen Kreises umgibt.

9. Anzeigevorrichtung, aufweisend die Halbleiter-Lichtemissionsvorrichtung gemäß Anspruch 1.

## Revendications

1. Dispositif électroluminescent à semi-conducteur comprenant :
un substrat de croissance (1001) ;
une couche semi-conductrice d'un premier type de conductivité (1002) formée sur le substrat de croissance ;
une couche active (1003) formée dans une région partielle sur la couche semi-conductrice du premier type de conductivité (1002) ;
une couche semi-conductrice d'un second type de conductivité (1004) formée sur la couche active (1003) ;
une tranchée (1006) formée par gravure d'une portion d'une surface supérieure de la couche semi-conductrice du second type de conductivité (1004) ;
une couche semi-conductrice du second type de conductivité dopée à haute concentration (1005) formée sur la couche semi-conductrice du second type de conductivité (1004), dans lequel la tranchée (1006) est gravée à partir d'une région partielle de la surface de la couche semi-conductrice du second type de conductivité dopée à haute concentration (1005),
une pluralité de nanoparticules métalliques (1007) insérées dans la tranchée ;
dans lequel la tranchée (1006) est formée dans une région espacée d'une portion centrale de la surface de la couche semi-conductrice du second type de conductivité (1004) ;
une première électrode (1010) connectée à la couche semi-conductrice du premier type de conductivité ;
une seconde électrode (1009) espacée de la première électrode (1010) et connectée à la couche semi-conductrice du second type de conductivité (1004) ou à la couche semi-conductrice du second type de conductivité dopée à haute concentration (1005) ;
dans lequel la seconde électrode (1009) est connectée de manière à être en contact avec la portion centrale de la surface de la couche semi-conductrice du second type de conductivité (1004) ou avec la couche semi-conductrice du second type de conductivité dopée à haute concentration (1005) ; et
une couche isolante de passivation (1008) disposée entre les nanoparticules métalliques (1007) et la seconde électrode (1009), la couche de passivation recouvrant les première et seconde couches semi-conductrices (1002, 1004), la couche active (1003) et la couche semi-conductrice du second type de conductivité dopée à haute concentration (1005) qui y est exposée.

2. Dispositif électroluminescent à semi-conducteur selon la revendication 1, dans lequel la première électrode et la seconde électrode sont réalisées sous forme d'électrodes transparentes.

3. Dispositif électroluminescent à semi-conducteur selon la revendication 1, dans lequel une profondeur allant d'une surface de la couche semi-conductrice du second type de conductivité à une surface de fond de la tranchée est inférieure à une épaisseur de la couche semi-conductrice du second type de conductivité.

4. Dispositif électroluminescent à semi-conducteur selon la revendication 3, dans lequel la surface de fond de la tranchée est positionnée plus près d'une surface supérieure de la couche active que la surface de la couche semi-conductrice du second type de conductivité.

5. Dispositif électroluminescent à semi-conducteur selon la revendication 1, dans lequel les nanoparticules métalliques comprennent au moins un matériau parmi l'argent, l'aluminium ou l'or.

6. Dispositif électroluminescent à semi-conducteur selon la revendication 1, dans lequel la couche semi-conductrice du second type de conductivité dopée à haute concentration est positionnée plus haut que les nanoparticules métalliques.

7. Dispositif électroluminescent à semi-conducteur selon la revendication 1, dans lequel la seconde électrode est directement disposée sur la couche semi-conductrice du second type de conductivité dopée à haute concentration disposée entre les tranchées.

8. Dispositif électroluminescent à semi-conducteur selon la revendication 1, dans lequel une pluralité de tranchées est formée selon une forme de cercles concentriques, dans lequel les tranchées en forme de cercles concentriques comprennent une première tranchée en forme de cercle concentrique et une seconde tranchée en forme de cercle concentrique espacée et entourant la première tranchée en forme de cercle concentrique.

9. Dispositif d'affichage comprenant le dispositif électroluminescent à semi-conducteur selon la revendication 1.
